Europäisches Patentamt

European Patent Office

Office européen des brevets

(11) Veröffentlichungsnummer: 0 180 751
A2

# EUROPÄISCHE PATENTANMELDUNG

(21) Anmeldenummer: 85112052.7

(22) Anmeldetag: 24.09.85

(51) Int. Cl.4: C30B 25/18 , H01L 31/18

(30) Priorität: 10.10.84 DE 3437233

(43) Veröffentlichungstag der Anmeldung:
14.05.86 Patentblatt 86/20

(84) Benannte Vertragsstaaten:
DE FR GB IT

(71) Anmelder: Siemens Aktiengesellschaft
Berlin und München Wittelsbacherplatz 2
D-8000 München 2(DE)

(72) Erfinder: Krühler, Wolfgang, Dr.
Ludwig-Thomas-Strasse 80
D-8025 Unterhaching(DE)
Erfinder: Grabmaier, Josef, Dr.
Am Seefeld 17
D-8137 Berg(DE)

(54) Verfahren zum Herstellen von Galliumarsenid-Dünnschicht-Solar-zellen.

(57) Die Erfindung betrifft ein Verfahren zum Herstellen von Galliumarsenid-Dünnschicht-Solarzellen auf billigenm Substratmaterial (1), bei dem zur Begünstigung des epitaktischen Wachstums der Galliumarsenidschichten (4, 5, 6) eine Zwischenschicht (2) aus hochdotiertem amorphen Germanium verwendet wird. Auf die hochdotierte amorphe Germaniumschicht (2) wird zur Erzeugung von Zentren (3) mit definierter Kristallorientierung an bestimmten vorgegebenen Punkten eine energiereiche Strahlung gerichtet, so daß bei der epitaktischen Gasphasenabscheidung von diesen Zentren (3) ausgehend sich die epitaktische Schicht (4) lateral flächendeckend ausbreitet. Die durch gezieltes Kornwachstum (7) erzeugten Solarzellen sind auf einfache Weise mit einem hohen Reinheitsgrad herstellbar und besitzen einen mit bekannten monokristallinen Solarzellen gleichen Schichtaufbaus vergleichbaren Wirkungsgrad (größer 20 %).

EP 0 180 751 A2

Verfahren zum Herstellen von Galliumarsenid-Dünnschicht-Solarzellen.

Die Patentanmeldung betrifft ein Verfahren zum Herstellen von Dünnschicht-Solarzellen mit einem überwiegen aus Galliumarsenid bestehenden Halbleiterkörper, der durch epitaktische Abscheidung seiner Schichten aus der Gasphase auf einem elektrisch leitenden Substrat erzeugt wird und bei dem zur Begünstigung des epitaktischen Wachstums vor der Galliumarsenid-Abscheidung auf dem Substrat eine Germaniumschicht aufgebracht wird.

Ein Verfahren dieser Art ist aus der DE-OS 2714243 zu entnehmen.

Die Entwicklung von hocheffizienten (Wirkungsgrade größer 20 %), billigen und stabilen Solarzellen hat bis heute noch zu keinem zufriedenstellenden Ergebnis geführt. Es sind Dünnschicht-Solarzellen aus amorphem Silizium bekannt, die zwar kostengünstig im Glimmentladungsverfahren herstellbar sind, aber eine geringe Stabilität und einen zu niedrigen Wirkungsgrad (ungefähr 5 %) besitzen.

Desweiteren sind kristalline Silizium-Solarzellen bekannt, die mit hoher Flächengeschwindigkeit in Bänder- oder Folienform kostengünstig hergestellt werden können, aber einen zu niedrigen Wirkungsgrad aufweisen.

Ein hoher Wirkungsgrad wird erzielt, wenn die kristallinen Siliziumsolarzellen nach konventionellen Kristallzüchtungsverfahren, also mit niedriger Flächengeschwindig keit hergestellt werden. Sie sind relativ teuer und für eine Massenproduktion ungeeignet.

Ein wichtiger Faktor bei der Herstellung kristalliner Solarzellen ist auch die Wahl geeigneten Ausgangsmaterials. Es soll billig und einfach verarbeitbar sein und die für einen hohen Wirkungsgrad entsprechende Reinheit besitzen.

Dünnschicht-Solarzellen aus Galliumarsenid, wie beispielsweise aus der eingangs genannten DE-OS 2714243 bekannt, weisen einen höheren theoretischen Wirkungsgrad (24 bis 28 %) als die vorgenannten kristallinen Siliziumsolarzellen auf; die Herstellung der Galliumarsenid-Epitaxieschichten mit ausreichender Korngröße, vorzugsweise in Kolumnarstruktur, bereitet jedoch Schwierigkeiten. Ein weiteres Problem ist auch die Auswahl an billigem Substratmaterial mit Gitteranpassung.

Die Erfindung stellt sich die Aufgabe, die eben beschriebenen Probleme zu lösen und auf der Basis von Galliumarsenid als Halbleiterkörper billige, hocheffiziente und stabile Solarzellen herzustellen.

Die erfindungsgemäße Aufgabe wird bei einem Verfahren der eingangs genannten Art durch den Ablauf folgender Verfahrensschritte gelöst:

a) es werden billige Substrate wie metallisiertes Glas oder Flächensilizium verwendet, auf denen die Germaniumschicht hochdotiert und im amorphen Zustand niedergeschlagen wird,

b) die amorphe Germaniumschicht wird an bestimmten vorgegebenen Punkten oder Linien mittels energiereicher Strahlung in Bezirke mit definierter Kristallorientierung übergeführt und

c) die Parameter bei der Gasphasenepitaxie des Galliumarsenid werden so eingestellt, daß sich ausgehend von den Kristallisationsbezirken die epitaktische Schicht lateral flächendeckend ausbreitet, bis die Kristallfront benachbarter Epitaxiebezirke aneinander stossen.

Die Erfindung macht sich dabei die aus dem Aufsatz von Shirley S. Chu et. al. aus dem Jorunal of Applied Physics, Vol. 48, Nr. 11, November 1977, auf den Seiten 4848 bis 4849 gewonnene Erkenntnis der Begünstigung des Wachstums von Galliumarsenidschichten auf rekristallisierten Germaniumschichten zunutze, verwendet aber zur Kristallisierung energiereiche Strahlung, wobei die erzeugten Kristallisationsstrukturen, die vorzugsweise im Bereich von 100 µm liegen, die Korngröße in der wachsenden Schicht vorgeben.

Vorteilhafte Weiterbildungen der Erfindung ergeben sich aus den Unteransprüchen.

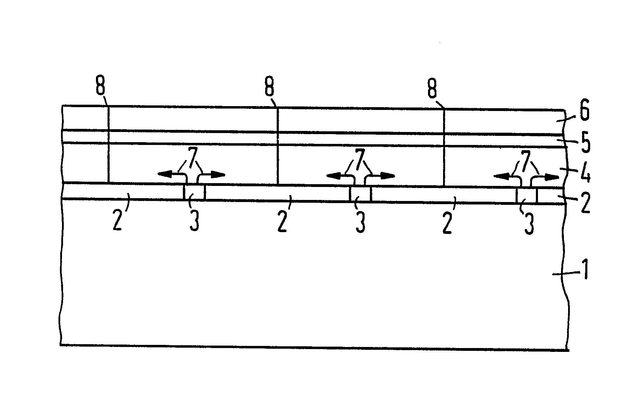

Die Erfindung wird im folgenden anhand der Figur, welche im Schnittbild eine durch das erfindungsgemäße Verfahren hergestellte Dünnschicht-Solarzelle darstellt, noch näher erläutert.

Mit dem Bezugszeichen 1 ist ein Substratkörper aus beispielsweise metallisiertem Glas oder einem durch Bandziehen gewonnen Flächensilizium bezeichnet. Darauf wird eine hochdotierte, amorphe Germaniumschicht 2 (a-Ge:P:H) mit einem Phosphorgehalt von mindestens 1 % durch Zersetzen von German (GeH$_4$) und Phosphin (PH$_3$) in einem Niederdruck-Glimmentladungsreaktor in einer Schichtdicke von 0,2 bis 0,5 µm abgeschieden.

Diese Germanium-Phosphor-Schicht 2 wird mit Hilfe eines gepulsten oder Dauerstrich-Laser geeigneter Wellenlänge (für Germanium im Bereich von 1 µm) an bestimmten Punk ten 3 (oder Linien) vorzugsweise mit <001> - oder <111> -Orientierung kristallisiert. Diese Kristallisierung läßt sich auch mit einem Elektronenstrahl erreichen. Die <001> - und die <111> -Orientierung sind bevorzugte Kristallorientierungen für Germanium.

Eine nachfolgende, in bekannter Weise durchgeführte und auch für die Herstellung von Solarzellen geeignete Gallium-Arsenid-Epitaxie, zum Beispiel aus der metallorganischen Verbindung Ga(CH$_3$)$_3$ und Arsen-Wasserstoff oder aus Arsen-Wasserstoff (AsH$_3$) und Galliumtrichlorid (GaCl$_3$) setzt an den Kristallisationspunkten (Linien) 3 an. Eine Abscheidung von Galliumarsenid (4) auf den amorphen Bereichen der Germanium-Phosphor-Schicht 2 kann wegen der fehlenden Gitteranpassung nicht stattfinden.

Das Gallium-Arsenid der Schicht 4 breitet sich ausgehend von den vorgegebenen Kristallisationspunkten 3, deren Abstände vorzugsweise zwischen 100 und 200 µm liegen und deren Ausdehnung sich über ca. 5 µm erstrecken, in Pfeilrichtung 7 lateral flächendeckend aus, bis die Kristallfronten benachbarter "Epitaxiebereich" (3) aufeinander treffen. Die Wachstumsflächen sind (001)- oder (111)-Flächen. An den Treffpunkten bilden sich Korngrenzen 8, die sich aber senkrecht oder annähernd senkrecht zur Substratoberfläche 1 ausbilden und so für die Stromsammlung der Solarzelle keinen nennenswert schädlichen Einfluß ausüben. Außerdem können die Korngrenzen 8 durch den bei der Epitaxie aus der amorphen Germanium-Phosphor-Schicht 2 ausdiffundierenden Wasserstoff passiviert werden.

Erfolgt die Abscheidung des Galliumarsenids bei Temperaturen zwischen 700 und 800°C, so scheidet sich das Galliumarsenid kristallin ab. Bei diesen Temperaturen kann das amorphe Germanium kristallisieren, wodurch das Galliumarsenid-Kornwachstum begünstigt wird. Die hoch dotierte Germanium-Phosphor-Schicht 2 bildet den ohmschen Kontakt der Galliumarsenid-Solarzelle zum leitenden Rückkontakt (Substrat 1).

Die mit dem Laser erzeugten Kristallisationstrukturen (3) werden im Bereich von 100 µm gewählt; diese Struktur gibt dann konsequenterweise auch die Korngröße vor. Wie aus der Literatur bekannt ist, reichen bereits 10 µm große Körner aus, um den hohen Wirkungsgrad von monokristallinen Galliumarsenid-Solarzellen zu erreichen.

Die erste Galliumarsenid-Schicht 4, welche beispielsweise mit einer aus Zink bestehenden Dotierung vom n-Leitungstyp abgeschieden wird, weist eine Schichtdicke von 3 bis 5 µm auf. Darauf wird in bekannter Weise eine zweite Galliumarsenid-Schicht 5 vom p-Leitungstyp mit Zinn als Dotierstoff in einer Schichtdicke von 0,2 bis 1 µm abgeschieden und schließlich die Anordnung mit einer Schicht 6 bestehend aus einem Gallium-Aluminium-Arsen-Mischkristall bedeckt. Die Schicht 6, welche eine Schichtdicke von 0,5 bis 1 µm aufweist, ist p-dotiert und dient als Fensterschicht. Sie weitet den Bandabstand zwischen Leitungs-und Valenzband auf und verhindert Oberflächenrekombinationen.

Da die einzelnen Prozeßschritte nacheinander durch einfaches Zuschalten der verschiedenen Reaktionsgase in einem abgeschlossenen System ablaufen, wird in kostengünstiger Weise eine hohe Reinheit der amorphen hochdotierten Germaniumschicht 2 gewährleistet, so daß die sonst empfindliche Galliumarsenid-Gasphasenepitaxie von störenden Fremdkeimen nicht initiiert werden kann.

**Ansprüche**

1. Verfahren zum Herstellen von Dünnschicht-Solarzellen mit einem überwiegend aus Galliumarsenid bestehenden Halbleiterkörper, der durch epitaktische Abscheidung seiner Schichten aus der Gasphase auf einem elektrisch leitenden Substrat erzeugt wird und bei dem zur Begünstigung des epitaktischen Wachstums vor der Galliumarsenid-Abscheidung auf dem Substrat eine Germaniumschicht aufgebracht wird, **dadurch gekennzeichnet,daß**

a) billige Substrate (1) wie metallisiertes Glas oder Flächensilizium verwendet werden, auf denen die Germaniumschicht (2) hochdotiert und im amorphen Zustand niedergeschlagen wird,

b) die amorphe Germaniumschicht (2) an bestimmten vorgegebenen Punkten oder Linien mittels energiereicher Strahlung in Bezirke (3) mit definierter Kristallorientierung übergeführt wird, und

c) die Parameter bei der Gasphasenepitaxie des Galliumarsenid so eingestellt werden, daß sich ausgehend von den Kristallisationsbezirken (3) die epitaktische Schicht (4) lateral flächendeckend ausbreitet, bis die Kristallfronten benachbarter Epitaxiebezirke (3) aneinander stossen.

2. Verfahren nach Anspruch 1, **dadurch gekennzeichnet,** daß als hochdotierte Germaniumschicht (2) eine aus Germanium und mindestens 1 % Phosphor bestehende Schicht verwendet wird, die durch Zersetzen von einem aus German ($GeH_4$) und Phosphin ($PH_3$) bestehenden Gasgemisch in einem Niederdruck-Glimmentladungsreaktor erzeugt worden ist.

3. Verfahren nach Anspruch 2, **dadurch gekennzeichnet,** daß die Schichtdicke der Germaniumschicht (2) auf 0,2 bis 0,5 µm eingestellt wird.

4. Verfahren nach mindestens einem der Ansprüche 1 bis 3, **dadurch gekennzeichnet,** daß zur Erzeugung der Bezirke (3) mit definierter Kristallorientierung, vorzugsweise mit 001 - oder 111 -Orientierung, ein gepulster oder Dauerstrich-Laser mit einer im Bereich von 1 µm liegenden Wellenlänge verwendet wird.

5. Verfahren nach Anspruch 4, **dadurch gekennzeichnet,** daß anstelle der Laserstrahlung Elektronenstrahlung verwendet wird.

6. Verfahren nach mindestens einem der Ansprüche 1 bis 5, **dadurch gekennzeichnet,** daß die Bestrahlung so geführt wird, daß die Abstände der Kristallisationsbezirke (3) im Bereich zwischen 20 und 1000 µm, vorzugsweise zwischen 100 und 200 µm, liegen.

7. Verfahren nach mindestens einem der Ansprüche 1 bis 6, **dadurch gekennzeichnet,** daß als Reaktionsgase bei der Galliumarsenid-Epitaxie (4, 5, 6) ein Gemisch aus Arsenwasserstoff ($AsH_3$) mit metallorganischen Galliumverbindungen oder mit Galliumtrichlorid ($GaCl_3$) und mit entsprechenden gasförmigen Dotierstoffen verwendet wird.

8. Verfahren nach Anspruch 7, **dadurch gekennzeichnet,** daß Galliumtrimethyl ($Ga(CH_3)_3$) verwendet wird.

9. Verfahren nach mindestens einem der Ansprüche 1 bis 8, **dadurch gekennzeichnet,** daß die epitaktische Abscheidung von Gal liumarsenid (4, 5, 6) bei Temperaturen zwischen 700 und 800°C durchgeführt wird.